# EUROPEAN PATENT APPLICATION

(11) **EP 4 485 502 A1**
(43) Date of publication of application: **01.01.2025**
(21) Application number: 22928965.7
(22) Date of filing: 22.12.2022
(51) Int. Cl.: H01L 21/02, H01L 21/20, H01L 27/12, H01L 29/16

(54) **RADIO-FREQUENCY DEVICE SUBSTRATE, AND METHOD FOR MANUFACTURING SAME**

(30) Priority: 24.02.2022 JP 2022026305
(71) Applicant: Shin-Etsu Handotai Co., Ltd., Tokyo 100-0004 (JP)
(72) Inventor: MATSUBARA, Toshiki, Nishishirakawa-gun, Fukushima 961-8061 (JP); SUZUKI, Katsuyoshi, Annaka-shi, Gunma 379-0196 (JP); TANAKA, Yuki, Nishishirakawa-gun, Fukushima 961-8061 (JP); SUZUKI, Atsushi, Nishishirakawa-gun, Fukushima 961-8061 (JP); ABE, Tatsuo, Nishishirakawa-gun, Fukushima 961-8061 (JP); OHTSUKI, Tsuyoshi, Nishishirakawa-gun, Fukushima 961-8061 (JP)
(74) Representative: Mooser, Sebastian Thomas
(86) International application number: PCT/JP2022/047481
(87) International publication number: WO 2023/162448

(57) **Abstract**

The present invention is a substrate for a high-frequency device including a support substrate having unevenness on a surface thereof, a diamond layer on the surface of the support substrate, and a silicon oxide film layer on the diamond layer. Thereby, the substrate for a high-frequency device using diamond having excellent high-frequency characteristics and a method for producing a substrate for a high-frequency device using diamond having excellent high-frequency characteristics are provided.

## Description

### TECHNICAL FIELD

The present invention relates to a substrate for a high-frequency device, and a method for producing the same.

### BACKGROUND ART

With the arrival of 5G, devices have been required to be compatible with a wide frequency band, requiring a large number of high-frequency components such as a filter. In particular, semiconductor devices used in the high-frequency range, i.e., semiconductor devices for high-frequency (RF) applications, are required to have higher performance.

High-frequency filters and the like using silicon substrates with SOI structures have conventionally attracted attention from the viewpoint of their excellent compatibility with CMOS process and the possibility of mass production. In addition, from the viewpoint of preventing cross-talk, harmonic characteristics have been regarded as important, and various measures have been taken to improve these characteristics, such as increasing resistivity of substrates and introducing a charge storage layer.

A specific solution, in the first place, is an increase in the resistivity of a support substrate. For example, Patent Document 1 discloses that a specific value of resistance must have an electrical resistivity of typically higher than 500 Q.cm, preferably higher than 1000 Q.cm, and more preferably higher than 3000 Q.cm.

In addition, Patent Document 2 discloses a method for producing an SOI substrate for high-frequency (TR-SOI substrate) provided with a support substrate having a SOI structure, and a new intermediate semiconductor layer (charge trap layer or trap-rich: TR layer) such as Poly-Si between the support substrate and a buried oxide layer (BOX layer).

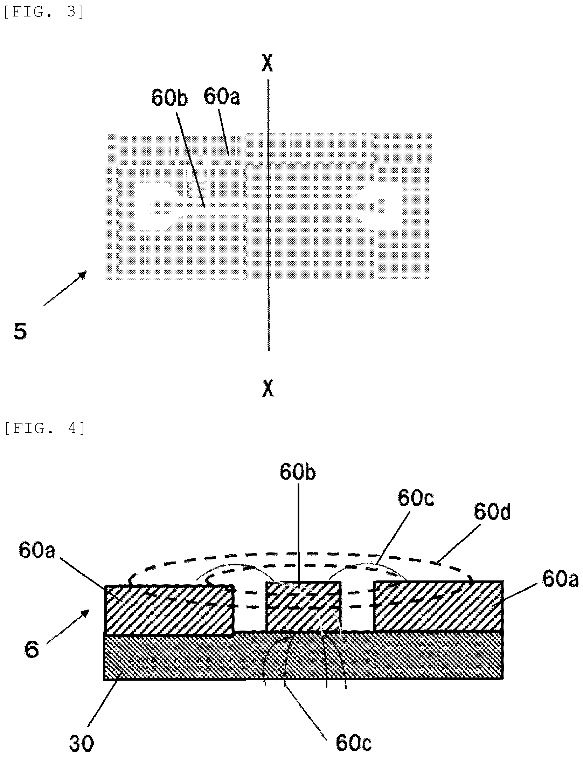

High-frequency characteristics of such a substrate for a high-frequency device include second harmonic (2HD) characteristics measured by forming a Co-Planar Waveguide (CPW 5) shown in, e.g., FIG. 3 with an Al electrode on the BOX layer by removing a SOI layer of TR-SOI substrate. CPW 5 is referred to as a device 6, as an example shown in FIGs. 3 and 4, having a structure including: metal electrodes 60a arranged in parallel with a gap; and linear central metal electrodes 60b formed at centers of the gap and in parallel to these metal electrodes 60a. The device 6 transmits electromagnetic waves with electric field 60c directed from the central metal electrodes 60b toward the metal electrodes 60a on both right and left sides and inward to a to-be-measured substrate 30; and a magnetic field 60d directed to surround the central metal electrodes 60b inside the to-be-measured substrate 30 as shown in FIG. 4.

In addition, a harmonic is referred to as a higher frequency component having an integer multiple frequency of an original frequency. The original frequency is defined as a fundamental wave, and a wave having a double frequency (a half wavelength) is defined as 2HD. In a high-frequency circuit, a substrate with a small harmonic is required in order to avoid interference due to the harmonic, and for this purpose, as described above, a TR layer is formed on a base substrate in TR-SOI, and furthermore, the support substrate is made highly resistive to improve 2HD characteristics.

In Patent Document 3, a substrate using a material other than a silicon-based material is disclosed as such a substrate for a high-frequency device. In Patent Document 3, diamond is grown on a substrate (silicon in Example), and a piezoelectric material is further film-formed. An example thereof includes a structure, in which ZnO is formed, and an electrical resistivity of the piezoelectric material is specified as 10¹⁴ Ω·cm or less.

### CITATION LIST

### PATENT LITERATURE

Patent Document 1: JP 2015-503853 A
Patent Document 2: JP 2019-129195 A
Patent Document 3: JP 2004-336600 A

### SUMMARY OF INVENTION

### TECHNICAL PROBLEM

Further improvement of the performance of the substrate for a high-frequency device described above is desired.

The present invention is to solve the problem described above. An object of the present invention is to provide a substrate for a high-frequency device using diamond having excellent high-frequency characteristics and a method for producing a substrate for a high-frequency device using diamond having excellent high-frequency characteristics.

### SOLUTION TO PROBLEM

To achieve the object described above, the present invention provides a substrate for a high-frequency device comprising:
a support substrate having unevenness on a surface thereof;
a diamond layer on the surface of the support substrate; and
a silicon oxide film layer on the diamond layer.

By using diamond, improvement of high-frequency characteristics can be expected due to improvement of heat-dissipating property using excellent thermal conductivity of diamond and a property of a highest speed of sound in substances. In addition, the substrate for a high-frequency device is made with an enhanced insulating property by providing the silicon oxide film layer on the diamond layer.

In addition, in the present invention, it is preferred that the surface of the support substrate has a surface roughness (Sa) measured by AFM of 1 nm or more.

Such a substrate for a high-frequency device is preferable because carrier mobility in the support substrate is reduced.

Moreover, in the present invention, it is preferred that the support substrate having unevenness on the surface has a resistivity of 500 Q.cm or more.

By using the support substrate having such a high resistivity, the substrate for a high-frequency device having more excellent high-frequency characteristics can be obtained.

Furthermore, the present invention provides a method for producing a substrate for a high-frequency device, the method comprising the steps of:
providing a support substrate;
forming unevenness on a surface of the support substrate;
forming a diamond layer on the surface of the support substrate; and
forming a silicon oxide film layer on the diamond layer.

By using diamond, the production of the substrate for a high-frequency device having improved high-frequency characteristics can be expected due to improvement in heat-dissipating property by using high thermal conductivity of diamond and use of a material having characteristics that have the highest speed of sound in substances. Moreover, by forming the silicon oxide film layer on the diamond layer, an insulating property is expected.

In addition, in the present invention, it is preferred that the step of forming unevenness on the surface of the support substrate is the step of forming roughness so as to make a surface roughness (Sa) of the support substrate measured by AFM of 1 nm or more.

Such a substrate for a high-frequency device is preferable because the carrier mobility in the support substrate is reduced.

Moreover, in the present invention, it is preferred that the support substrate has a resistivity of 500 Q.cm or more.

By using the support substrate having such a high resistivity, the substrate for a high-frequency device having more excellent high-frequency characteristics can be produced.

### ADVANTAGEOUS EFFECTS OF INVENTION

As described above, according to the inventive substrate for a high-frequency device, it is possible to improve the high-frequency characteristics by using diamond due to the improvement of the heat-dissipating property using the high thermal conductivity of diamond, the property of the highest speed of sound in substances and presence of the silicon oxide film with the high insulating property.

In addition, according to the inventive method for producing a substrate for a high-frequency device, it is possible to produce the substrate for a high-frequency device in which the high-frequency characteristics are improved by using diamond due to the improvement of the heat-dissipating property using the high thermal conductivity of diamond, the property of the highest speed of sound in substances and presence of the silicon oxide film having the high insulating property.

### BRIEF DESCRIPTION OF DRAWINGS

FIG. 1 is a schematic view illustrating an example of a substrate for a high-frequency device according to the present invention.
FIG. 2 is a schematic flow diagram illustrating an example of a method for producing a substrate for a high-frequency device according to the present invention.
FIG. 3 is a schematic plane view of an example of a Co-Planar Waveguide (CPW) used for evaluating second harmonic characteristics.
FIG. 4 is a cross-sectional view of CPW along a line segment X-X in FIG. 3.

### DESCRIPTION OF EMBODIMENTS

As described above, it is required to develop a substrate for a high-frequency device with excellent high-frequency characteristics and a method for producing such a substrate for a high-frequency device.

Accordingly, the present inventors have earnestly studied the above problems and consequently found that, as a substrate for a high-frequency device, improvement of high-frequency characteristics is enabled by using one substrate for a high-frequency device having a support substrate having unevenness on a surface thereof, a diamond layer stacked on the surface, and a silicon oxide film further stacked on the diamond layer.

That is, the present invention is a substrate for a high-frequency device comprising:
a support substrate having unevenness on a surface thereof;
a diamond layer on the surface of the support substrate; and
a silicon oxide film layer on the diamond layer.

Moreover, the present invention is a method for producing a substrate for a high-frequency device, the method comprising the steps of:
providing a support substrate;
forming unevenness on a surface of the support substrate;
forming a diamond layer on the surface of the support substrate; and
forming a silicon oxide film layer on the diamond layer.

Note that Patent Document 3 discloses a structure, in which a piezoelectric film (ZnO film in Example) formed on a diamond grown on a silicon substrate, but a resistivity of the silicon substrate is not particularly specified, and unevenness is absent on a surface of the silicon substrate, and further, a piezoelectric layer stacked on the diamond has an electrical resistivity of 10¹⁴ Ω·cm or less which is smaller than an electrical resistivity of the silicon oxide film (10¹⁵ Q.cm or more, for example, 10¹⁷ Ω·cm). The structure and configuration are different from those of the present invention.

Hereinafter, the present invention will be described in detail. However, the present invention is not limited thereto.

### [Substrate for High-Frequency Device]

The inventive substrate for a high-frequency device includes the support substrate having unevenness on the surface thereof, the diamond layer stacked on the surface, and the silicon oxide film layer further stacked on the diamond layer.

In other words, the present invention is the substrate for a high-frequency device that improves the high-frequency characteristics by using diamond due to the improvement of the heat-dissipating property using the high thermal conductivity of diamond, the property of the highest speed of sound in substances, and the stacking of the silicon oxide film having the high insulating property.

It is preferred to provide unevenness on the surface of the support substrate to reduce the carrier mobility in the support substrate and to set this unevenness as Sa=1 nm or more in AFM measurement. The upper limit of unevenness is not particularly limited but can be, for example, 50 nm or less.

The resistivity of the support substrate is desirably 500 Q.cm or more. By providing the support substrate having such a high resistivity, it is possible to obtain the substrate for a high-frequency device having more excellent high-frequency characteristics. The upper limit of the resistivity is not particularly limited but can be, for example, 10000 Q.cm or less.

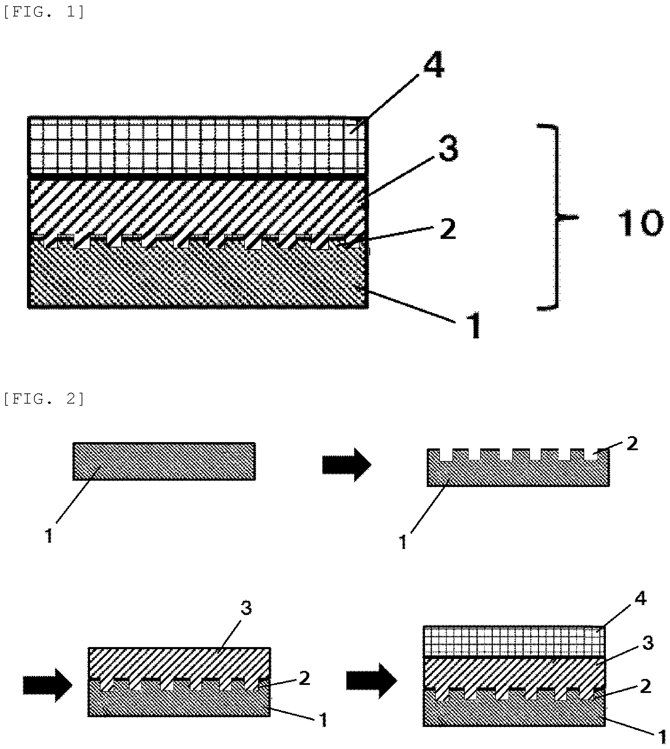

Next, referring to FIG. 1, an example of the inventive substrate for a high-frequency device is specifically described.

FIG. 1 shows a cross-sectional view of an inventive substrate 10 for a high-frequency device. The substrate 10 for a high-frequency device includes a support substrate 1, a diamond layer 3, and a silicon oxide film layer 4.

Unevenness 2 is formed on a surface of the support substrate 1 and given a role to hold charges formed between the support substrate 1 and the diamond layer 3 to prevent the charges from moving due to application of high frequency.

By stacking the silicon oxide film layer 4 thereon, a structure resembles an SOI structure; then, a high insulating property of this silicon oxide film layer 4, the diamond layer 3, and unevenness act as a carrier trap at an interface, blocking a high-frequency signal flowing through the support substrate 1, thereby reducing distortion of the high-frequency signal.

It can also be said that the substrate 10 for a high-frequency device has the structure in which the support substrate 1 having unevenness on the surface, the diamond layer 3, and the silicon oxide film layer 4 are stacked in this order.

### [Method for Producing Substrate for High-Frequency Device]

An inventive method for producing a substrate for a high-frequency device includes the steps of providing a support substrate, forming unevenness on a surface of the support substrate, forming a diamond layer on the surface of the support substrate, and forming a silicon oxide film layer on the diamond layer.

In other words, the present invention is the method for producing a substrate for a high-frequency device, in which the high-frequency characteristics are improved using diamond due to the improvement of the heat-dissipating property using the high thermal conductivity of diamond, the property of the highest speed of sound in substances, in addition to the silicon oxide film having the high insulating property.

Various methods of diamond layer synthesis are known, but for a semiconductor substrate application, CVD (Chemical Vapor Deposition) methods such as microwave plasma and hot filament are present. The hot filament method is preferred among these as the method can be applied to a large-diameter substrate.

The hot filament method is a method in which the substrate is placed into a pressure-reduced reaction furnace, and an electric current is applied to a tungsten filament provided above the substrate to generate high heat in a state where methane and hydrogen are introduced as gases, thereby decomposing and activating the gases to grow diamond.

When unevenness is provided on the surface of the support substrate to reduce the carrier mobility in the support substrate, it is preferred to make this unevenness measured by AFM Sa=1 nm or more.

The method of forming unevenness is not particularly limited but can be, for example, formed by grinding the support substrate surface.

In addition to the above-described function of reducing carrier mobility, unevenness at this time also plays a role in functioning as a nucleus during diamond growth.

In forming the silicon oxide film formed on the diamond layer, common thermal oxidization is unable to be used (because diamond is oxidized); thus, low-temperature film formations such as plasma CVD or ALD are preferable.

Moreover, it is desirable that the support substrate has a resistivity of 500 Q.cm or more, and by using the support substrate having such a high resistivity for the production, the substrate for a high-frequency device having more excellent high-frequency characteristics can be produced.

Next, referring to FIG. 2, an example of the method for producing an inventive substrate for a high-frequency device is specifically described.

Firstly, the support substrate 1 is provided. Then, unevenness 2 is formed on the surface of this support substrate 1.

Next, the diamond layer 3 is formed on unevenness 2 on the surface of the support substrate 1.

Next, the silicon oxide film layer 4 is further stacked on the diamond layer 3, thereby obtaining the substrate 10 for a high-frequency device.

As described above, the substrate 10 for a high-frequency device can be obtained, which is composed of the support substrate 1 having unevenness 2 on the surface, the diamond layer 3, and the silicon oxide film layer 4 as shown in FIGs. 1 and 2.

### EXAMPLES

Hereinafter, the present invention will be specifically described with reference to Example and Comparative Example. However, the present invention is not limited thereto.

### [Example]

A boron-doped silicon single-crystal substrate having a diameter of 300 mm with high resistivity (8000 Q.cm) was provided, and a surface thereof was surface-grinded by a grindstone having a size of #8000 to produce a substrate having a surface roughness of Sa=1 nm. Next, methane (CH₄) and hydrogen (H₂) were introduced into a hot filament CVD apparatus as raw materials, and growth was performed for 4 hours under the following conditions: filament temperature: 2200°C, H₂ flow rate: 10 SLM, CH₄ concentration: 3 %, substrate temperature: 850°C, 5 Torr (667 Pa) to form a diamond layer. A plasma CVD apparatus was then used to perform growth for 10 minutes using TEOS (tetraethoxysilane) as the raw material under the following conditions: TEOS: 40 sccm, substrate temperature: 350°C, 100 Torr (13332Pa) to form a silicon oxide film for 400 nm.

A device having CPW (line length: 2200 µm) formed by aluminum electrodes was produced on the substrate having the silicon oxide film, the diamond layer, and the silicon single-crystal substrate produced as described above. Subsequently, the second harmonic characteristics (2HD characteristic) (frequency: 1 GHz, input signal intensity: 15 dBm) were measured. As a result, 2HD characteristics of -113 dBm being improved over Comparative Example described later was observed.

### [Comparative Example]

A boron-doped silicon single-crystal substrate having a diameter of 300 mm having high resistivity (8000 Q.cm) was provided as a support substrate, and a polysilicon layer was grown for 1.8 um at 1050°C on this silicon single-crystal substrate having high resistivity. Subsequently, a silicon single-crystal substrate having a thermal oxide film of 400 nm was provided and then bonded to the silicon single-crystal substrate having high resistivity on which the polysilicon layer was formed, and then a part of the silicon single-crystal substrate was removed and the thermal oxide film of 400 nm was transferred to the support substrate to produce a TR-SOI substrate having the polysilicon layer as an intermediate layer (trap-rich layer) and the thermal oxide film as an insulating film in the silicon single-crystal substrate having high resistivity.

The SOI layer of this TR-SOI substrate was etched with NaOH, and then a device having CPW (line length: 2200 µm) formed by aluminum electrodes was produced on the exposed insulating film. Subsequently, second harmonic characteristics (2HD characteristics) (frequency: 1 GHz, input signal intensity: 15 dBm) were measured. As a result, the 2HD of the substrate in Comparative Example was -93 dBm.

From the results shown above, the substrate for a high-frequency device having unevenness on the surface of the support substrate, diamond, and the silicon oxide film formed by CVD successfully exhibited excellent high-frequency characteristics.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A substrate for a high-frequency device comprising:
a support substrate having unevenness on a surface thereof;
a diamond layer on the surface of the support substrate; and
a silicon oxide film layer on the diamond layer.

2. The substrate for a high-frequency device according to claim 1, wherein
the surface of the support substrate has a surface roughness (Sa) measured by AFM of 1 nm or more.

3. The substrate for a high-frequency device according to claim 1 or 2, wherein
the support substrate having unevenness on the surface has a resistivity of 500 Q.cm or more.

4. A method for producing a substrate for a high-frequency device, the method comprising the steps of:
providing a support substrate;
forming unevenness on a surface of the support substrate;
forming a diamond layer on the surface of the support substrate; and
forming a silicon oxide film layer on the diamond layer.

5. The method for producing the substrate for a high-frequency device according to claim 4, wherein
the step of forming unevenness on the surface of the support substrate is the step of forming roughness so as to make a surface roughness (Sa) of the support substrate measured by AFM of 1 nm or more.

6. The method for producing the substrate for a high-frequency device according to claim 4 or 5, wherein
the support substrate has a resistivity of 500 Q.cm or more.
